(19) Europäisches Patentamt / European Patent Office / Office européen des brevets

(11) **EP 2 464 019 A1**

(12) **EUROPEAN PATENT APPLICATION**

(43) Date of publication:
**13.06.2012 Bulletin 2012/24**

(51) Int Cl.:
***H03M 13/25*** (2006.01)

(21) Application number: **10290645.0**

(22) Date of filing: **09.12.2010**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(71) Applicant: **NXP B.V.
5656 AG Eindhoven (NL)**

(72) Inventors:
 • **Marchand, Cedric
 Redhill, Surrey RH1 1DL (GB)**

 • **Boutillon, Emmanuel
 Redhill, Surrey RH1 1DL (GB)**

(74) Representative: **Burton, Nick et al
 NXP Semiconductors
 Intellectual Property and Licensing
 Red Central
 60 High Street
 Redhill
 Surrey RH1 1NY (GB)**

(54) **Low density parity-check code decoding**

(57)    A method and apparatus for layered decoding of a codeword encoded using a Low Density Parity-check code. The code defines a plurality of variable nodes corresponding to the bits of the codeword and a plurality of check nodes. Each check node is associated with two or more variable nodes. The method comprises: defining (510) a plurality of layers, each layer comprising a group of nodes of one type to be updated together; detecting (520) a conflict within a layer, wherein first and second nodes among the group of nodes are associated with a third node of the other type, whereby, in an update-step of the decoding method, both the first and second nodes will attempt to write to a memory address corresponding to the third node; and repeating the update-step, to avoid the conflict, comprising: performing a first update-step (530, 540, 550) wherein the second node updates the third node; and performing a second update-step (560, 570, 580) wherein the first node updates the third node.

FIG 8

EP 2 464 019 A1

**Description**

This invention relates to a method and apparatus for decoding a Low Density Parity-Check (LDPC) code. It is particularly relevant to LDPC codes defined by a parity-check matrix comprising sub-matrices having multiple diagonals of non-zero entries. Such codes are used, for example, in the Digital Video Broadcasting (DVB) second generation standards: DVB-S2; DVB-T2; and DVB-C2, for transmission of video via satellite, terrestrial, and cable, respectively.

LDPC codes have gained much attention due to their remarkable error correcting capabilities. Structured LDPC codes are now defined for use in several standards, such as the 2nd Generation Satellite Digital Video Broadcast (DVB-S2) standard, ratified in 2005. The 2nd Generation Terrestrial DVB (DVB-T2) standard, which was adopted in 2009, and the 2nd Generation Cable DVB (DVB-C2), which will be adopted during 2010 include a common Forward Error Correction (FEC) block with the DVB-S2 standard. Here, a "structured" code means that the parity check matrix has been designed with a regular structure, so as to permit easier encoding and decoding.

An LDPC code is defined by a parity-check matrix. This is a sparse matrix of ones and zeros, defining a set of constraints that must be met by the bits of a valid codeword. Each column of the matrix corresponds to one bit of the codeword. Each row of the matrix corresponds to a parity constraint that must be met by the bits associated with that row. The non-zero entries in the matrix define connections between bits and constraints. This is traditionally represented as a bipartite graph, with connections (edges) between a set of variable-nodes (corresponding to the bits) and a set of constraint- or check-nodes (corresponding to the parity checks). The modulo-2 sum of all the bits connected to one check-node must be zero.

In practice, LDPC codes are usually decoded by an iterative process of Belief Propagation (BP), in which check nodes are updated, based on the available information about the values of the variable nodes; and variable nodes are updated, based on the available knowledge about the check nodes. Much work has focused on developing effective strategies for processing these updates, so that the decoding algorithm converges quickly to the correct codeword. The information associated with each node is usually represented in a probabilistic fashion, such as a real-valued probability for each node. At the variable (bit) nodes, these probability values are known as Soft Outputs (SO).

Layered decoding is one promising strategy for organising the iterations. In a layered decoder, one of the two sets of nodes (the check or variable nodes) is divided into multiple groups, called layers. All nodes in the same layer are processed together. The different layers are processed in succession, so that the updated information generated by one layer will be used as input to the next. This allows the algorithm to converge more quickly. However, because groups of nodes are processed together, the method is amenable to parallel implementation in which the updates for all nodes in the same group are calculated concurrently. The updating of each group of nodes is known as a "sub-iteration".

Although the DVB-S2, DVB-T2 and DVB-C2 standards define structured parity-check matrices, these matrices cannot be decoded using a layered decoder architecture because they contain overlapped sub-matrices - also known as Double Diagonal Sub-Matrices (DDSM). For layered decoding, it is a requirement that no two nodes in the same group are connected to a common node of the other type. If two nodes in the group are associated with the same node of the other type, it means that both nodes will attempt to update the same node in the same sub-iteration. This would lead to conflicts in the Soft Output (SO) memories.

According to an aspect of the present invention, there is provided: a method of layered decoding for a codeword encoded using a Low Density Parity-check code, the code defining a plurality of variable nodes corresponding to the bits of the codeword and a plurality of check nodes, each check node being associated with two or more variable nodes, the method comprising:

defining a plurality of layers, each layer comprising a group of nodes of one type to be updated together;
detecting a conflict within a layer, wherein first and second nodes among the group of nodes are associated with a third node of the other type, whereby, in an update-step of the decoding method, both the first and second nodes will attempt to write to a memory address corresponding to the third node; and
repeating the update-step, to avoid the conflict, comprising:

performing a first update-step wherein the second node updates the third node; and
performing a second update-step wherein the first node updates the third node.

The method therefore enables the conflict to be resolved by processing the layer in two passes or phases. In each pass, (at least) one of the two conflicting nodes is processed. A value associated with the third node is updated by one of the two conflicting nodes in each pass. Thus, a value associated with the third node is updated twice in the same layer.

Without this repetition of the update-step, both the first and second nodes would try to update the third node in the same step. In this case, when the second node was processed, it would cause a value (of the third node) that was previously updated by the first node to be overwritten.

The second update step may be performed after the first update step has been completed. In embodiments, the second update-step relies on the output of the first-update step. In some embodiments, the first and second update-steps are performed consecutively. In other embodiments, it may be preferable to perform other update-steps, for other layers, between the first and second update steps. This can facilitate a pipelined implementation. In this case, the result of the first update will not emerge from the pipeline for several clock cycles. Nevertheless, the second update step will preferably use the output of the first update step as input; therefore, the second update step should not be started until the first update step has completed. In the intervening clock cycles, the pipeline can be used to process other layers. In this way, the first and second updates for one layer may be temporally interleaved with the first and second updates for other layers.

The! first update step preferably comprises: calculating the value of a message to be passed from each node in the group of nodes to each node of the other type with which it is associated; calculating an updated value for each node of the other type, based on each message; and writing the updated values to memory addresses corresponding to the nodes of the other type, wherein, when the updated value based on the message from the first node to the third node is to be written to the memory address corresponding to the third node, a write function of the memory is disabled.

Before the updated value from the first node can be written to the memory address of the third node, the memory is write-disabled. Write-disabling the memory is one simple yet effective way of resolving the conflict. This solution can enable the conflict to be resolved without major modification to the architecture of the decoder. The update step is simply repeated with the write function of the memory selectively disabled at the appropriate time.

By preventing the updated value from the first node from being written to the memory address, the updated value based on the message from the second node to the third node is thereby written to the memory address of the third node and preserved there.

A message passed between the nodes may comprise a Log Likelihood Ratio (LLR). The value written to the memory address of the third node may be its Soft Output (SO) value.

The first update step preferably further comprises: storing the value of each message in a memory, wherein, when the value of the message from the first node to the third node is to be written to the memory, a write function of the memory is disabled.

In some implementations, message values may be preserved between iterations of the update-step. However, if an update-step is repeated (as is done in the present method) the message values would then be updated twice and an error would be introduced. The correct calculation should use the original (previous iteration) value of the message for each repetition of the update-step. Therefore, a convenient and efficient way to avoid the error is to disable the writing of the message value in the first repetition.

The second update step preferably comprises: calculating the value of a message to be passed from each node in the group of nodes to each node of the other type with which it is associated; calculating an updated value for each node of the other type, based on each message; and writing the updated values to memory addresses corresponding to the nodes of the other type, wherein, when the updated value based on the message from the second node to the third node is to be written to the memory address corresponding to the third node, a write function of the memory is disabled.

This is the equivalent of the method described above for the first update step. By disabling the write function of the memory before the second node can update the third node, the updated value generated by the first node is preserved. That is, the second updated value is prevented from overwriting the first updated value.

The nodes of the first type may be check nodes and the nodes of the other type may be variable nodes.

This provides a horizontally layered decoder, wherein each layer comprises a group of check nodes. Each sub-iteration then comprises updating each the check node of the group with the latest information from its associated variable nodes, followed by updating each of the associated variable nodes with newly calculated messages from the check node. The method of the present invention controls how these updates occur when two check nodes in the same layer are associated with a shared variable node.

Alternatively, the nodes of the first type may be variable nodes and the nodes of the other type may be check nodes.

This provides a vertical layered decoder. Note that, considered by itself, a vertical layered decoder is normally less efficient than horizontal scheduling. However, when combined in a feedback loop with phase noise mitigation and i

LLR computation, for example, the use of vertical scheduling can result in a very efficient iterative receiver.

Preferably, the calculation of messages to be passed from each node in the group of nodes to each node of the other type with which it is associated is performed concurrently for all nodes of the group.

It is advantageous if the update step for all nodes in the same layer can be performed in parallel, because this increases the throughput of the algorithm. The values from the other nodes needed to calculate the messages may be read sequentially (serially) from memory. The calculations may then be performed in parallel (concurrently). Then the calculated updated values may be written back to the memory sequentially (serially).

The step of detecting the conflict may comprise detecting a multiple diagonal parity-check matrix.

The method may be particularly beneficial when the conflict, arises because of a double-diagonal, or other multiple-diagonal block in the parity-check matrix. A conflict is indicated by two connections to a third element, within the same layer. Therefore, if a multiple-diagonal block exists, this means that similar conflicts exist for all the nodes in the layer. In this case, the present method is able to easily resolve all the conflicts simultaneously, by a number of repetitions of the layer that is equal to the number of diagonals in the matrix.

Also provided is a computer program comprising computer program code means adapted to perform all the steps of any preceding claim when said program is run on a computer; and such a computer program embodied on a computer readable medium.

According to another aspect of the invention, there is provided a layered decoder for decoding for a codeword encoded with a Low Density Parity-check code, the code defining a plurality of variable nodes corresponding to the bits of the codeword and a plurality of check nodes, each check node being associated with two or more variable nodes, the decoder comprising:

a plurality of node processors, operable to perform updates for a plurality of layers, one layer at a time, each layer comprising a group of nodes of a first type;
a memory, for storing values associated with nodes of the other type;
a conflict-detection circuit, adapted to detect a conflict within a layer, wherein first and second nodes among the group of nodes in the layer are associated with a third node of the other type, whereby, in an update-step performed by the decoder, node processors corresponding to the first and second nodes will attempt to write a value to a location in the memory corresponding to the third node; and
a controller, adapted to control the plurality of node processors to repeat the update-step, in order to avoid the conflict, wherein the node processors are controlled:

to perform a first update-step wherein the second node updates the memory address of the third node; and
to perform a second update-step wherein the first node updates the memory address of the third node.

This decoder is specially adapted to implement the method described previously above. The number of nodes in the layer is preferably equal to the number of node processors. Each node processor then corresponds to one of the nodes in the layer.

Each node processor is preferably adapted: to calculate the values of messages to be passed from a node in the group of nodes to each node of the other type with which it is associated; to calculate an updated value for each node of the other type, based on each message; and to write the updated values to locations in the memory corresponding to the nodes of the other type, and wherein the controller is adapted to control a write function of the memory such that, during the first update step, when the updated value calculated by the node processor for the first node is to be written to the memory location of the third node, the write function of the memory is disabled.

The decoder preferably further comprises a message memory associated with each check node processor, wherein: each check node processor is adapted to store the value of each message in its associated message memory; and the controller is adapted to control a write function of each message memory such that, during the first update step, when the value of the message from the first node to the third node is to be written to the message memory of the first node, the write function of that message memory is disabled the controller preferably being further adapted to control the write function of each message memory such that, during the second update step, when the value of the message from the second node to the third node is to be written to the message memory of the second node, the write function of that message memory is disabled.

The message memory may be a Random Access Memory.

In the prior art, the messages are ordinarily stored in a First-In First-Out (FIFO) buffer. However, in the present apparatus, the message values will be updated more than once per iteration. The messages should be read and written to the same memory address in both update steps. A Random Access Memory (RAM) enables this.

The controller is optionally further adapted to control a write function of the memory such that, during the second update step, when the updated value calculated by the node processor for the second node is to be written to the memory location of the third node, the write function of the memory is disabled.

The invention will now be described by way of example with reference to the accompanying drawings, in which:

Fig. 1 shows the structure of a rate-2/_3 DVB-T2 Matrix with N=16200;
Fig. 2 is a block diagram of a soft-output based check node processor
Fig. 3 is an enlarged view of the matrix of Fig. 1;
Fig. 4 indicates diagonal and double-diagonal sub-matrices in the matrix of Fig. 1;
Fig. 5 illustrates the principle of repeating a layer, according to embodiments of the invention;
Fig. 6 shows the architecture of an exemplary LDPC decoder;
Fig. 7 shows the architecture of a modified layered LDPC decoder according to an embodiment of the invention;

Fig. 8 is a higher-level block diagram of the decoder of Fig. 7; and
Fig. 9 is a flowchart of a method according to an embodiment.

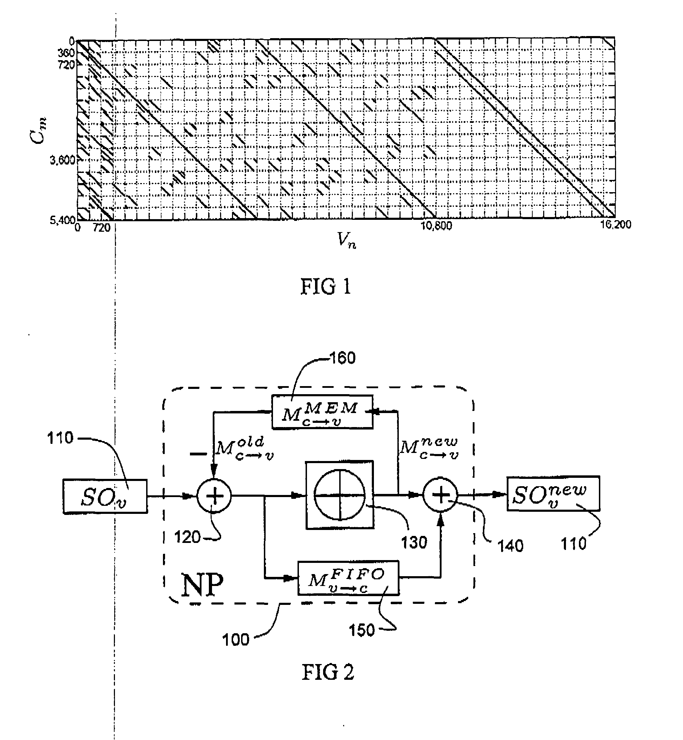

Fig. 1 shows the structure of the rate 2/3 short-frame DVB-T2 LDPC parity check matrix. The matrix is structured with shifted identity matrices. The non-zero entries in the matrix (shown in black) show the links between Variable Nodes (VN) and Check Nodes (CN). This structure is efficient for highly parallel decoders. In the following description, after an overview of the layered decoder principle, the DVB-T2 LDPC matrices will be used as an example, in order to explain how memory conflicts arise.

In the horizontal layered decoding algorithm, a VN is represented by a SO value (SOv). Before the first iteration, this value is initialized by the Channel Log Likelihood Ratio: LLR = log(P(v=0)/P(v=1)). That is, the LLR is the logarithm of ratio of the probability that a zero was transmitted to the probability that a one was transmitted. The decoding then proceeds iteratively until all the parity checks are verified or a maximum number of iterations is reached.

For layered decoding, each iteration is split into sub-iterations, with one sub-iteration for each layer. Firstly, consider the case that a layer consists of just one CN. In each sub-iteration, all the VNs connected to this CN are updated. The update of the VNs connected to one CN is done serially in three steps. First, the message $M_{v \to c}$ from VN to CN is calculated using the equation (I):

$$M_{v \to c} = SO_v - M_{c \to v} \qquad (1)$$

The second step is the serial $M_{c \to v}$ update, where $M_{c \to v}$ is a message from CN to VN. For implementation convenience, the sign (2) and the absolute value (3) of the messages are updated separately, Let $v_c$ be the set of all the VN connected to the CN c and $v_c/v$ be $v_c$ without $v$.

$$sign\left(M_{c \to v}^{new}\right) = \prod_{v' \in v_c/v} sign\left(M_{v' \to c}\right) \qquad (2)$$

$$M_{c \to v}^{new} = f\left( \sum_{v' \in v_c/v} f\left(|M_{v' \to c}|\right) \right) \qquad (3)$$

Here, $f(x) = \ln\left( \tanh\left( \frac{x}{2} \right) \right)$.. Equation (3) can also be implemented directly in the time domain or using any sub-optimal algorithm such as the Min-Sum algorithm the normalized Min-Sum algorithm, A-min algorithm or the $\lambda$-min algorithm. These algorithms may be found in the following references:

- Min-sum algorithm: M.P.C Fossorier, M. Mihaljevic, and H. Imai. "Reduced complexity iterative decoding of low-density parity check codes based on belief propagation". IEEE Transactions on communications, 47:673-680, May 1999.
- Normalized min-sum: J. Chen and M. Fossorier. "Density evolution of two improved bp-based algorithms for LDPC decoding". IEEE Communication letters, March 2002.
- Lambda-min: F. Guilloud, E. Boutillon, and J.-L. Danger. "lambda-min decoding algorithm of regular and irregular LDPC codes". Proceedings of the 3rd International Symposium on Turbo Codes and Related Topics, September 2003.
- A-min*: C. Jones, E. Valles, M. Smith, and J. Villasenor. "Approximate-min* constraint node updating for LDPC code decoding". In IEEE Military Communication Conference, pages 157-162, October 2003. The third step is the calculation of the $SO^{new}$ value using (4):

$$SO_v^{ncw} = M_{v \to c} + M_{c \to v}^{new} \qquad (4)$$

According to layered decoding, the updated $SO^{ncw}$ value can be used in the same iteration by another sub-iteration (that is, by another layer). This leads to convergence that may be twice as fast, compared to decoding according to the conventional flooding schedule.

From these equations, the Check-Node Processor (CNP) architecture shown in Fig. 2 can be derived. The left part of the architecture is deduced from (1) and the right part is deduced from (4). The central part is in charge of the $M_{c \to v}$ update. In the present embodiment, the update is performed serially; however, this is not essential: the update can be bit-serial, for example, or two SOs can be updated in one clock cycle. In the present embodiment, SO values for each of the variable nodes associated with the check node are read in sequence from (and written to) an SO memory 110. The CNP 100 is comprised of the following parts. Adder 120 implements equation (1). The result of this subtraction is input to the message update part 120, which implements equations (2) and (3) (or other sub-optimal algorithm, as already noted above), in order to calculate the sign and value of the messages from the check node to each of the variable nodes, in turn. To calculate the resulting new SO values, each message is added to the previously calculated message from that variable node to the check node, according to equation (4). This is implemented by adder 140. The messages $M_{v \to c}$ from variable to check-node are fed forward in a FIFO buffer 150 to the adder 140. The newly calculated messages $M_{c \to v}$, from check-node to variable, are stored in a message memory 160 until the next iteration.

Several CNs may be grouped together and decoded in parallel to form a layer, provided that a column weight in the layer does not exceed one. A structured matrix made of identity matrices of size Z leads to layers made of Check-Node Groups (CG) of Z CNs. The layered decoder architecture is mainly based on Z CNPs that first read serially the Variable-Node Group (VG) of Z VNs linked to one CG and then the Z CNPs write back the result to the VGs in the same order. The described architecture is efficient for structured codes. However, memory conflicts arise when using this architecture for DVB-S2,-T2,-C2 matrices.

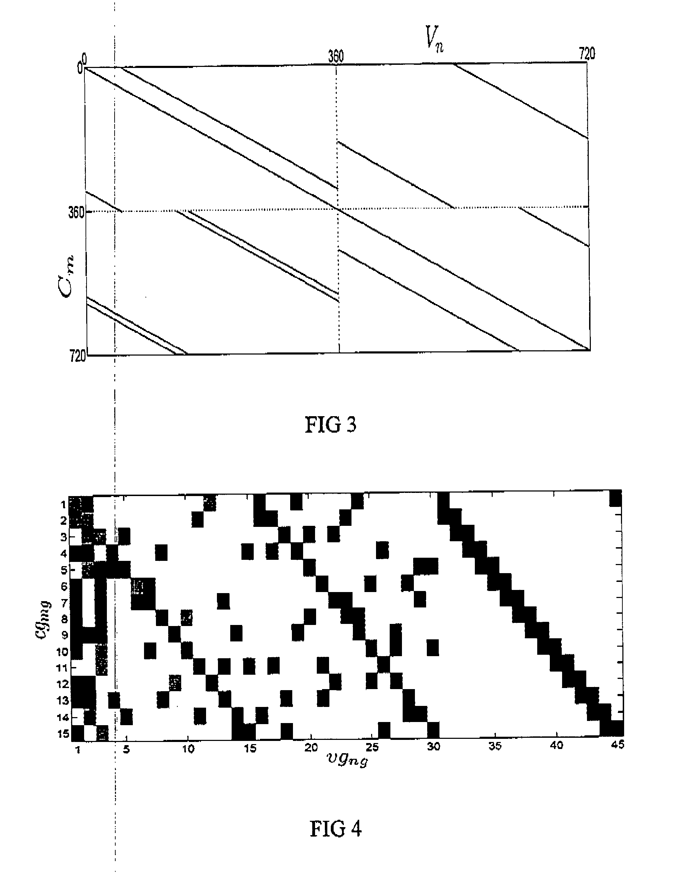

Fig. 3 shows an enlarged view of the first 720 VNs and CNs of the DVB-T2 LDPC matrix illustrated in Fig. 1. Note that the first group of 360 CNs is linked twice to the first group of 360 VNs by two diagonals. Such a sub-matrix with a double diagonal in it will be referred to as a Double Diagonal Sub-Matrix (DDSM).

Consider the case where two CN are computed in the same layer and connected to the same VN. There are two updates of the same SO value. The calculation of the new SO is given by (5). Defining the difference between old and new messages $M_{c \to v}$ as $M_{c \to v}$ as $\Delta M_{c_1 \to v} = M_{c_1 \to v}^{new} - M_{c_1 \to v}^{old}$ and using (5), we obtain the calculation of $SO_v^{new1}$ and $SO_v^{new2}$ in (6) and (7), respectively:

$$SO_v^{ncw} = SO_v^{old} - M_{c \to v}^{old} + M_{c \to v}^{new} \qquad (5)$$

$$SO_v^{new1} = SO_v^{old} + \Delta M_{c1 \to v} \qquad (6)$$

$$SO_v^{new2} = SO_v^{old} + \Delta M_{c2 \to v} \qquad (7)$$

Because the SO memory is updated serially in the layered architecture, after parallel computation of the updated values, the $SO_v^{new2}$ will overwrite the $SO_v^{new1}$ value. This conflict is equivalent to cutting the $M_{c \to v}$ message. This is usually called a cutting edge and will lead to performance degradation. Each DDSM will produce Z cutting edges and thus has to be avoided in the structure of the matrix.

As an example, Fig. 4 illustrates the number of DDSMs in the rate-2/3 short-frame matrix. $cg_{mg}$ denotes the $mg^{th}$ group of 360 CNs and $vg_{ng}$ denotes the $ng^{th}$ group of 360 VNs. A black square of X axis $vg_{ng}$ and Y axis $cg_{mg}$ denotes a permuted identity matrix linking $cg_{mg}$ and $vg_{ng}$. On this base matrix, each gray square corresponds to a DDSM.

Note that there are 14 DDSMs in this example. These 14x360 cutting edges lead to a performance degradation that renders the layered decoder unsuitable to decode this LDPC code.

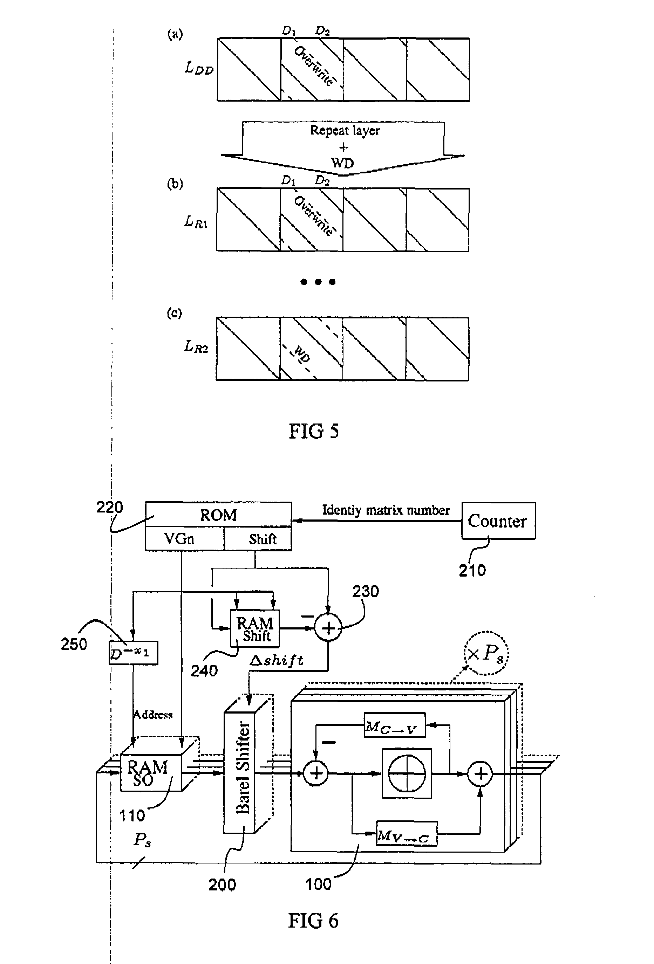

Fig. 5 illustrates the principle of a decoding method according to an embodiment of the invention. Fig. 5(a) shows a sub iteration layer having one DDSM. The SOs are read and written in the same order as they appear in the matrix - that is, from left to right. With a normal layered decoder, the result of the diagonal D2 in the DDSM would overwrite the result of the diagonal D1. D1 is shown with a dashed line, indicating the sources of the updated SO values that will be overwritten.

The present inventors have recognized that the conflict between the diagonals can be resolved by disabling one of the two updates and repeating the processing of the layer.

For example, if equation (7) is disabled, then SO is not overwritten any more, as shown in Fig. 5(c). The present inventors have recognized that this can conveniently be implemented by using the write enable of the SO memory (typically RAM). It is then possible to update the layer twice during the same iteration. A control circuit detects the layers that have DDSM and uses a write disable when needed.

Figs. 5(b) and (c) show an example where the layer labelled LR1 is the first repetition and LR2 is the second repetition. During the first update step, the result from the left diagonal (D1) is overwritten but the result of the right diagonal (D2) is correctly updated. During the second update step, a write disable (WD) signal is generated by the controller, to prevent the D2 update. This time, the result of D1 is updated.

Care must be taken to maintain all data values correctly in spite of the repeated update. One beneficial way of achieving this will now be described, using a write-disable of the $M_{c \rightarrow v}$ memory.

During one sub iteration with one DDSM in it, from equations (5) and (6), the $SO_v^{new2}$ will overwrite the $SO_v^{new1}$ value. The edge of the Tanner graph connecting v and $c_1$ is virtually absent in the decoding process. This will lead to another error at the next iteration. At the next iteration, it is known from equation (1) that the $M_{v \rightarrow c_1}^{l+1}$ is given by:

$$M_{v \rightarrow c_1}^{l+1} = SO_v^{new2} - M_{c_1 \rightarrow v}^{l+1} \qquad (8)$$

Expanding (8) by using (5), we obtain the following:

$$M_{v \rightarrow c_1}^{l+1} = SO_v^{old} + \Delta M_{c_2 \rightarrow v} - M_{c_1 \rightarrow v}^{new} \qquad (9)$$

Considering that the edge c1→3v has been cut during the last iteration the equation should be:

$$M_{v \rightarrow c_1}^{l+1} = SO_v^{old} + \Delta M_{c_2 \rightarrow v} - M_{c_1 \rightarrow v}^{old} \qquad (10)$$

This results in a mistake with magnitude equal to $\Delta M_{c1 \rightarrow v}$. The false $M_{v \rightarrow c}$ value can propagate to all the variable nodes linked to this check node and thus impact on all the SO concerned in this sub-iteration. The inventors have recognised that a simple way to avoid this problem is to make sure that the $M_{c \rightarrow v}$ stays at the previous value ( $M_{c \rightarrow v}^{old}$ ) and thus $\Delta M_{c \rightarrow v}$ =0. This may be done by signalling a write disable of the $M_{c \rightarrow v}$ memory at the appropriate instant.

In summary, there is a need for an on time WD of the SO memory and the Mc→v memory as a function of which layer repetition (LR) is being processed (LR1 and LR2) and the diagonal number in the DDSM (D1 and D2). The write disable algorithm can be summarized by the following pseudo-code:

*Algorithm 1: Write disable algorithm*

```
if LR1 &D1 then
     WD Mc→v MEMORY ← 1
     WD SO MEMORY ←1
```

```
else if LR2 & D2 then
      WD Mc→v MEMORY ← 1
      Wd SO MEMORY ←1
else
      WD Mc→v MEMORY ← 0
      WD SO MEMORY ← 0
end if
```

Note that the ellipsis (...) between Fig. 5(b) and (c) indicate layers being processed between LR1 and LR2. These layers are included to avoid memory conflicts due to pipelining between LR1 and LR2, The processing of layers is performed one layer after the other, without delay, in order to avoid idle cycles. For example, if a layer has dc = 6, the decoder will need 6 clock cycles (t1 to t6) to read the SO message, a few clock cycles to pass through the barrel shifter, epsilon clock cycles (where epsilon is equal to one or two) to end the check node processing, and then 6 clock cycles to write the result. The second layer will start from read access from t7 to t12. Those 6 values should be distinct from the 6 values that have not already been written by the previous iteration. The updated SO values generated by in LR1 should preferably be used as the input to LR2. However, in a typical pipelined implementation, there will be a certain amount of latency between the start of the processing for LR1 and the generation of the updated SO values (the result). Therefore, processing of LR2 should not begin immediately after LR1 in the pipeline, Instead, other layers can be inserted in the pipeline between LR1 and LR2. Indeed, to allow LR2 to benefit from further updates to the SO value, the scheduling of the layers can be chosen to include as many layers as possible between LR1 and LR2. Note also that there is an advantage, in terms of convergence of the code, to maximally separate the repetition of the two layers. ideally, the separation should be equal to the number of layers divided by 2, since the separation should be effective within an iteration but also between successive iterations i and i+1.

According to other embodiments of the invention, the Mc→v messages may be compressed. To explain briefly: if the decoder uses a min-sum algorithm, for example, it should store dc messages on nb bits. When using the min-sum algorithm, the decoder only needs to store the default min value, the second min value and its index and the sign of the bit, which can represent a significant compression of the information. Other algorithms similar to min-sum achieve similar compression.

When using a compressed algorithm, all information is compressed together. It becomes impossible to separate the values that should be not be write disabled from the values that should be write disabled. To solve this problem, we propose a small extra memory to store the relevant values separately In this case, there is no further access to Mc→v Memory at address D1 or Mc→w Memory at address D2 in order for a write disable to keep them at their previous values.

For embodiments such as these, it is preferred to add an additional memory for Mc→v (D1) Memory and Mc→v (D2) Memory. Algorithm 1 can then be modified as follows:

*Algorithm 2: Write disable algorithm for min-sum*

```
if Layer = LR1 then
      if D1 then
            WD SO MEMORY←1
      else if D2 then
            WD Mc→v (D2) MEMORY ←0
      and if
else if Layer = LR2 then
      if D1 then
            WD Mc→v (D1) MEMORY←0
      else if D2 then
            WD SO MEMORY←1
      end if
else
else WD SO MEMORY ← 0
      WD Mc→v (D2) MEMORY ←1
      WD Mc→v (D1) MEMORY ←1
end if
```

A hardware architecture for a decoder according to an embodiment of the invention will now be described. For the purposes of a clear and general explanation, an example of a normal layered decoder with one barrel shifter will first be described. Then, the modifications that should be made to this architecture, in order to implement the write-disable architecture of the embodiment, will be described. From this explanation, those skilled in the art will understand the modifications that should be made to other types of decoder architecture, in order to implement the present invention.

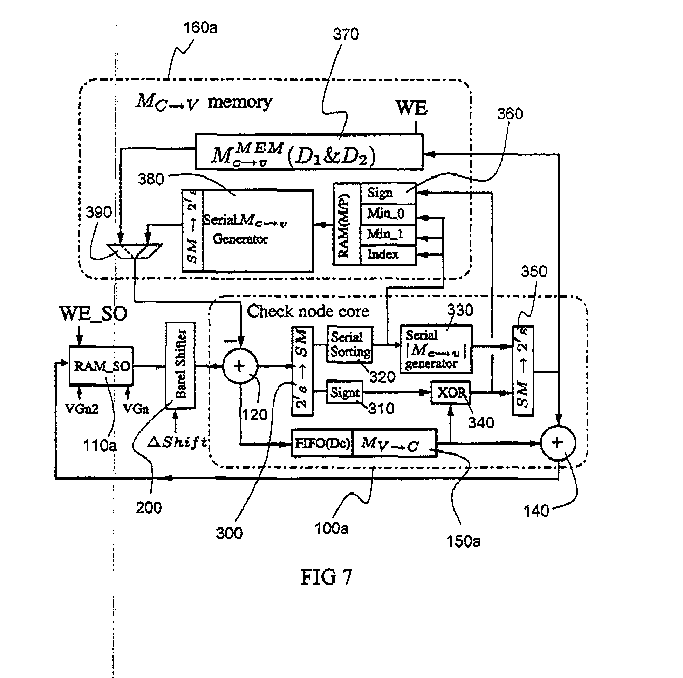

The architecture shown in Fig. 7 is a simple layered decoder. A counter 210 counts from 1 to $IM_{base}$ (that is, the number of identity matrices in the base matrix). A Read-Only Memory (ROM) 220 linked to the counter delivers the $VG_i$ addresses and the associated shift value according to the base matrix order. The size of the ROM 220 dedicated to store $VG_i$ and $Shift_i$ is $IM_{base} \times$ (log2(S x N/360)+ log2(360/S)).

In this architecture, the delta-shift generator 230, 240 allows just one barrel shifter 200 to be used instead of two. In many conventional decoders, a first barrel shifter would deliver the SO values read from the memory 110 to the check node processors 100 and a second barrel shifter would deliver the updated SO values back to the correct memory addresses. In the present decoder, the values in SO RAM 110 are not put back in their original order by a second barrel shifter; instead, during the next read of the values, the barrel shifter 200 is controlled so that the new shift takes into account the locations of the results from the previous iteration. At the next call of a VG, the SOs in this group are already stored in the SO RAM 110 shifted by the shift value of the previous call ($shift^{old}_{VGn}$). The Delta_shift value takes into account the shift value of the previous calls by the following subtraction:

$$Delta\_Shift = shift^{new}_{VGn} - shift^{old}_{VGn}.$$

This operation is implemented by the adder 230. The shift value from the previous iteration. $Shift^{old}_{VGn}$, is stored in a RAM 240 of size V GN $\times$ log2(PS).

The SO value read from the SO RAM 110 is written back to the same RAM at the same address after being updated by the CNP, with a delay of $x_1$ cycles. Here x1 is the total delay and should be equal to dc + epsilon + the delay of the barrel shifter (that is, the total number of clock cycles between the reading of a variable node from memory and its writing back after processing. Epsilon depends on the pipeline delay of the check node architecture. In each CNP 100, the $M_{v \to c}$ memory is implemented using a FIFO of size dc. For the SO RAM 110, a dual-port RAM with one port for writing and the other for reading is used for pipelining. The write-addresses for the dual port RAM are generated a delayed version of the read-addresses. The correct delay between read and write is introduced by delay element 250, which receives $VG_i$ addresses from the ROM 220 and outputs a suitably delayed version of them. Note that the $M_{c \to v}$ memory can be made of a FIFO memory as the $M_{c \to v}$ update will occur only once during each iteration.

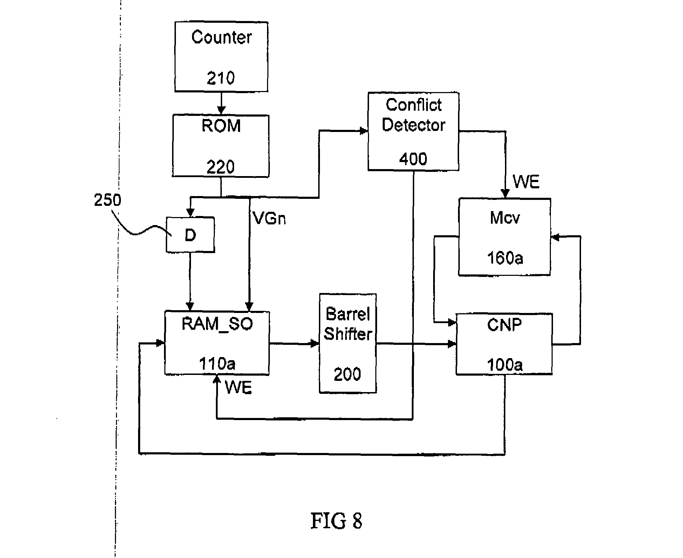

The improvements which enable the layered decoder to deal with the conflicts, according to the present embodiment, will now be described with reference to Fig.8,

When repeating layers, the $A_{c \to v}$ are updated more than once and the $M_{c \to v}$ read and write for the second repetition must be at the same address as during the first repetition. For this, reason, the FIFO $M_{c \to v}$ memory 160 of Fig. 2 and Fig. 7 is replaced with a RAM 160a with an ad-hoc address generator.

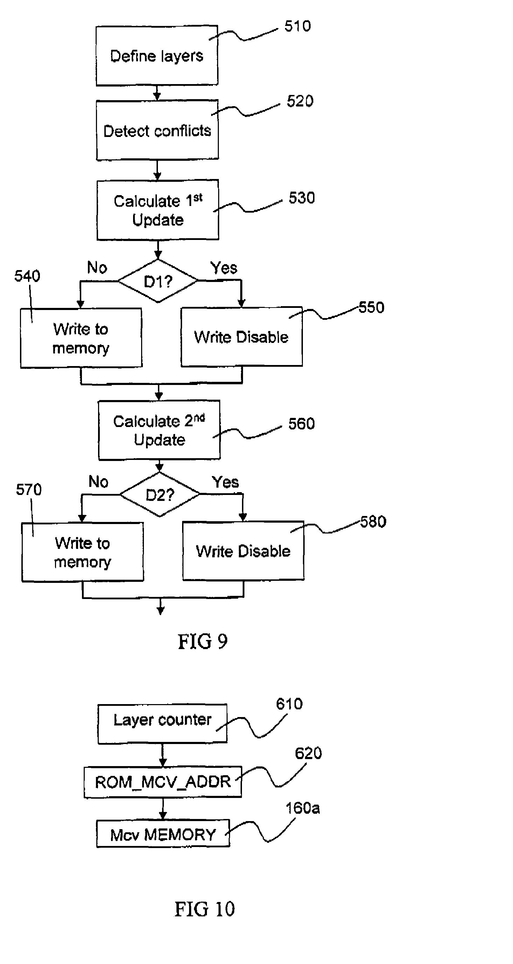

The address generator will be described in greater detail below, with reference to Fig. 10. The order of layers is predefined and computed offline. A Read-only memory (ROM) 620 stores this predefined order. The layer counter 610 counts up from one to the number of layers. This provides a layer index which is used to address the ROM 620. In response, the ROM 620 outputs the corresponding layer addresses in the correct order. When a layer is to be repeated, the address generator 610, 620 will output the same layer address as the first layer occurrence (according to the predefined order). The layer address is then used to address the Mc→v memory 160a. The address generator has been omitted from Fig. 7, for simplicity,

Fig 7 shows how the check node processor 100 of Fig 6 is modified in order to implement the invention. In the specific embodiment of Fig. 7, the decoder is implementing the min sum algorithm.

In the modified Check node core 1 00a, The Mv→c values arrive serially from adder 120 in two's complement representation. They are transformed to sign and magnitude representation in converter 300 so that the sign and magnitude of the messages can be computed separately. The serial sorting of the incoming magnitude values is implemented in sorter 320, in order to give Min_0, Min_1 and Index values until all the incoming messages are read. Here Min_0 refers to the minimum (lowest) among the magnitude values; Min_1 is the next lowest magnitude value ("second minimum"); and index is the index of the minimum.

In serial Mc→v generator 330, the Min_0, Min_1 and index values previously sorted are used to serially compute the new outgoing messages. An XOR function is computed recursively on the incoming sign bits in Signt block 310, until all the incoming messages are read. Next, an XOR function is computed in XOR block 340, between the output of Signt block 310 and the sign of the outgoing message Mv→c from the FIFO memory 150a.

The sign and magnitude from XOR processor 340 and serial Mc→v generator 330, respectively, are transformed into a two's complement representation in converter 350, ready for subsequent computations.

In the Mc→v memory 160a, the minimum Min_0, second minimum M_1, index value of the minimum and sign of each Mc→v linked to one check node are stored in RAM 360. From the minimum, second minimum, index and sign, the serial Mc→v generator 380 computes the two's complement representation of the Mc→v value. This part of the calculation corresponds to the conventional Mc→v storage of a Min-sum algorithm. Meanwhile, the Mc→v messages'from diagonal 1 and diagonal 2 are stored separately, in memory 370. A multiplexer 390 selects the Mc→w message appropriately - either from memory 370 (for the diagonals) or 380 (for messages other than the diagonals).

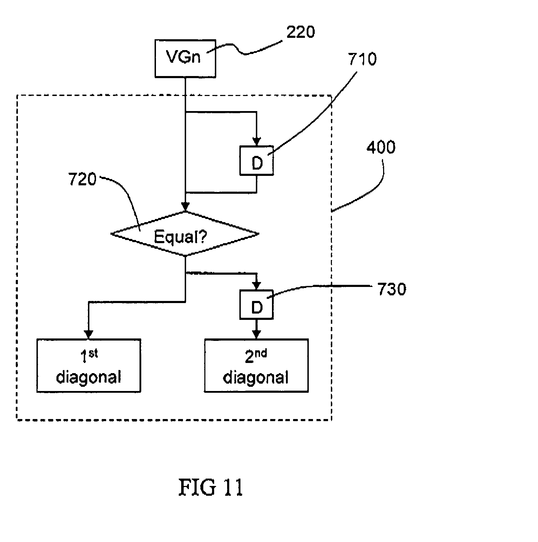

The cutting-edge detection principle relies on the detection of DDSM. When there is a DDSM, during the serial read of the VGs, two equal VGns value follow one another, as a result of the same variable nodes being accessed twice by different check nodes in the layer. This can be easily detected at the output of ROM_VGn 220 where the base matrix is stored. The cutting edge detector (conflict detection circuit) also detects whether a value being read from the SO memory corresponds to the first or second diagonal. Part of the circuitry of an exemplary conflict detection circuit is shown in Fig. 11. In this circuit, the address VG is delayed by one cycle in delay element 710 and compared with the most recent address VG in comparator 720. If the two values are equal, this means that there is a double diagonal. The output of the comparator 720 signals the first diagonal and is delayed in 730 to signal the second diagonal. The repeat layer detection allows the decoder to detect when there is a repeated layer and if it is the first or the second layer. The appropriate WD SO and WD Mc→v signals are derived from the algorithms explained previously above. In the case of an implementation using the sum-product approach, Algorithm 1 is appropriate; in the case of an implementation using a min-sum approach, Algorithm 2 is appropriate.

Fig. 8 illustrates a simplified block diagram of the decoder. The decoder comprises a memory 110a, for storing SO values; and a message memory 160a for storing messages between iterations. A write-enable function of each of these memories is controlled by a conflict detector 400. The conflict detector detects memory access conflicts within each layer, by examining the addresses output by the address ROM 220 (as described above). The ROM 220 is in turn controlled by counter 210. Together the counter 210, ROM 220 and conflict detector 400 comprise a control circuit, adapted to control when layers are repeated. The actual calculations for each layer are executed by CNPs 100a. The CNPs receive SO values from RAM_SO 110a, after they have been appropriately shifted by the barrel shifter 200. Updated SO values are returned to the RAM 110a without a further barrel shift, as already explained above.

A method executed by the decoder of Fig. 8 is illustrated in the flowchart of Fig. 9. The method begins by defining 510 a plurality of layers and detecting 520 a conflict within a layer. In this embodiment, the conflict is caused by a DDSM having diagonals D1 and D2. In step 530, a first repetition of the update for the layer is calculated. Then, the results of the first update are written to memory. For results corresponding to D1. the write enable function of the memory is disabled 550, preventing the results being stored. For all other updates, the results are stored 540. A second repetition of the updates for the layer is then calculated 560. This time, for all results other than D2, the results are stored 570 in the memory. For results corresponding to D2, the write-enable function of the memory is disabled and these results are prevented from being written.

The performance of the decoding algorithm according to an embodiment was tested for a rate 2/3, short frame with a normalized min-sum algorithm. A reference level of performance was based on a parity-check matrix having no conflicts and 30 iterations. To compare the performance at a constant throughput, the number of iterations was reduced as a function of the number of repeated layers in the present algorithm. With a parallelism of 360 (14DDSM), the bit-error curve for the present algorithm was within 0.1 dB of the reference. This shows that introducing DDSM (and therefore memory access conflicts) does not reduce the performance of the present algorithm and that this is achieved even without increasing the computational complexity.

While the invention has been illustrated and described in detail in the drawings and foregoing description, such illustration and description are to be considered illustrative or exemplary and not restrictive; the invention is not limited to the disclosed embodiments.

For example, it is possible to operate the invention in an embodiment wherein the decoder is a vertically layered decoder. In such an embodiment, the nodes of the first type are variable nodes, and the nodes of the other type are check nodes. The layers thus comprise groups of variable nodes. Those skilled in the art will understand, by analogy with the teaching above, how to implement a vertically layered decoder with layer repetition to avoid conflicts.

In the embodiments described above, each time a layer is repeated it is repeated in full. In other words, all of the message values and updated node values are calculated in each repetition. Conflicts are avoided by controlling the Write Enable (WE) functions of the relevant memories, when the values are being written to memory. However, this implies that some values are calculated but not stored, in each repetition. In other embodiments, it is possible that the calculation of the message values and node values may also be controlled, so that only values that will be stored in the memory are actually calculated This may avoid redundant calculations. However, the complexity of the implementation may increase correspondingly, because of the more sophisticated control required.

The embodiments described above use a write enable/disable signal to i prevent values in memory from being overwritten. However, this is just one possible solution. In other embodiments, overwriting may be prevented by means of other control mechanisms.

In the embodiments described above, the write-disable signals are derived at run-time (that is online), by examining the sequence of addresses output by the address generators. However, those skilled in the art will appreciate that this is just one possible implementation. For example, as an alternative, the write-disable could be computed offline (that is, determined in advance) and stored directly in the address ROMs 220, 620.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single processor or other unit may fulfil the functions of several items recited in the claims. The mere fact that certain measures are recited in mutually different dependent claims does not indicate that a combination of these measured cannot be used to advantage. A computer program may be stored/distributed on a suitable medium, such as an optical storage medium or a solid-stat medium supplied together with or as part of other hardware, but may also be distributed in other forms, such as via the internet or other wired or wireless telecommunication systems. Any reference signs in the claims should not be construed as limiting the scope.

## Claims

1. A method of layered decoding for a codeword encoded using a Low Density Parity-check code, the code defining a plurality of variable nodes corresponding to the bits of the codeword and a plurality of check nodes, each check node being associated with two or more variable nodes, the method comprising:

   defining (510) a plurality of layers, each layer comprising a group of nodes of one type to be updated together;
   detecting (520) a conflict within a layer, wherein first and second nodes among the group of nodes are associated with a third node of the other type, whereby, in an update-step of the decoding method, both the first and second nodes will attempt to write to a memory address corresponding to the third node;and
   repeating the update-step, to avoid the conflict, comprising:

   performing a first update-step (530, 540, 550) wherein the second node updates the third node; and
   performing a second update-step (560, 570, 580) wherein the first node updates the third node.

2. The method of claim 1, wherein the first update step comprises:

   calculating (530) the value of a message to be passed from each node in the group of nodes to each node of the other type with which it is associated;
   calculating (530) an updated value for each node of the other type, based on each message; and
   writing (540) the updated values to memory addresses corresponding to the nodes of the other type,
   wherein, when the updated value based on the message from the first node to the third node is to be written to the memory address corresponding to the third node, a write function of the memory is disabled (550).

3. The method of claim 2, wherein the first update step further comprises:

   storing (540) the value of each message in a memory, wherein, when the value of the message from the first node to the third node is to be written to the memory, a write function of the memory is disabled (550).

4. The method of any of claims 1 to 3, wherein the second update step comprises:

   calculating (560) the value of a message to be passed from each node in the group of nodes to each node of the other type with which it is associated;
   calculating (560) an updated value for each node of the other type, based on each message; and
   writing (570) the updated values to memory addresses corresponding to the nodes of the other type,
   wherein, when the updated value based on the message from the second node to the third node is to be written to the memory address corresponding to the third node, a write function of the memory is disabled (580).

5. The method of any of claims 1 to 4, wherein the nodes of the first type are check nodes and the nodes of the other type are variable nodes.

6. The method of any preceding claim, wherein the calculation of messages to be passed from each node in the group of nodes to each node of the other type with which it is associated is performed concurrently for all nodes of the group.

7. The method of any preceding claim, wherein the step of detecting the conflict comprises detecting a multiple diagonal parity-check matrix.

8. A computer program comprising computer program code means adapted to perform all the steps of any preceding claim when said program is run on a computer.

9. A computer program as claimed in claim 11 embodied on a computer readable medium.

10. A layered decoder for decoding for a codeword encoded with a Low Density Parity-check code, the code defining a plurality of variable nodes corresponding to the bits of the codeword and a plurality of check nodes, each check node being associated with two or more variable nodes, the decoder comprising:

> a plurality of node processors (100a), operable to perform updates for each layer of a plurality of layers, each layer comprising a group of nodes of a first typed
> a memory (110a), for storing values associated with nodes of the other type;
> a conflict-detection circuit (400), adapted to detect a conflict within a layer, wherein first and second nodes among the group of nodes in the layer are associated with a third node of the other type, whereby, in an update-step performed by the decoder, node processors (100a) corresponding to the first and second nodes will attempt to write a value to a location in the memory corresponding to the third node; and
> a controller (210, 220, 400), adapted to control the plurality of node processors (100a) to repeat the update-step, in order to avoid the conflict, wherein the node processors are controlled:

>> to perform a first update-step wherein the second node updates the memory address of the third node; and
>> to perform a second update-step wherein the first node updates the memory address of the third node.

11. The layered decoder of claim 10, wherein each node processor is adapted:

> to calculate the values of messages to be passed from a node in the group of nodes to each node of the other type with which it is associated;
> to calculate an updated value for each node of the other type, based on each message; and
> to write the updated values to locations in the memory (110a) corresponding to the nodes of the other type, and wherein the controller (400) is adapted to control a write function (WE) of the memory (110a) such that, during the first update step, when the updated value calculated by the node processor for the first node is to be written to the memory location of the third node, the write function of the memory is disabled.

12. The layered decoder of claim 11, further comprising a message memory (160a) associated with each check node processor (100a), wherein:

> each check node processor (100a) is adapted to store the value of each message in its associated message memory (160a); and
> the controller (400) is adapted to control a write function of each message memory (160a) such that, during the first update step, when the value of the message from the first node to the third node is to be written to the message memory of the first node, the write function (WE) of that message memory (160a) is disabled, the controller preferably being further adapted to control the write function of each message memory such that, during the second update step, when the value of the message from the second node to the third node is to be written to the message memory of the second node, the write function of that message memory is disabled.

13. The decoder of claim 12, wherein the message memory (160a) comprises a Random Access Memory.

14. The layered decoder of any of claims 11 to 13, wherein the controller is further adapted to control a write function of the memory such that, during the second update step, when the updated value calculated by the node processor for the second node is to be written to the memory location of the third node, the write function of the memory is disabled.

FIG 1

FIG 2

FIG 3

FIG 4

FIG 5

FIG 6

FIG 7

FIG 8

FIG 9

FIG 10

FIG 11

Europäisches
Patentamt

European
Patent Office

Office européen
des brevets

# EUROPEAN SEARCH REPORT

**Application Number**

EP 10 29 0645

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | Guo, K.; Hei, Y.; Qiao, S.;: "A Parallel-Layered Belief-Propagation Decoder for Non-layered LDPC Codes", Academy Publisher Database , vol. 5, no. 5 5 May 2010 (2010-05-05), pages 400-408, XP002630946, ISSN: 1796-2021 Retrieved from the Internet: URL:http://ojs.academypublisher.com/index.php/jcm/article/viewFile/0505400408/1829 [retrieved on 2011-03-30] * abstract * * Paragraphs I,IIIA, IV, Vfigure 2 * ----- | 1-14 | INV. H03M13/25 |
| X | ARTHUR SEGARD ET AL: "A DVB-S2 compliant LDPC decoder integrating the Horizontal Shuffle Scheduling", INTELLIGENT SIGNAL PROCESSING AND COMMUNICATIONS, 2006. ISPACS '0 6. INTERNATIONAL SYMPOSIUM ON, IEEE, PI, 1 December 2006 (2006-12-01), pages 1013-1016, XP031092577, ISBN: 978-0-7803-9732-3 * Paragraph III * ----- -/-- | 1-14 | |

| | | | TECHNICAL FIELDS SEARCHED (IPC) |
|---|---|---|---|
| | | | H03M |

The present search report has been drawn up for all claims

| Place of search | Date of completion of the search | Examiner |
|---|---|---|
| The Hague | 1 April 2011 | Belardinelli, Carlo |

EPO FORM 1503 03.82 (P04C01)

Europäisches
Patentamt

European
Patent Office

Office européen
des brevets

## EUROPEAN SEARCH REPORT

**Application Number**

EP 10 29 0645

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | MENG LI ET AL: "Design and FPGA prototyping of a bit-interleaved coded modulation receiver for the DVB-T2 standard", SIGNAL PROCESSING SYSTEMS (SIPS), 2010 IEEE WORKSHOP ON, IEEE, PISCATAWAY, NJ, USA, 6 October 2010 (2010-10-06), pages 162-167, XP031792399, ISBN: 978-1-4244-8932-9 * abstract * * paragraphs [0001], [ 4.3] * | 1-14 | |
| Y | MARCHAND C ET AL: "Conflict Resolution by Matrix Reordering for DVB-T2 LDPC Decoders", GLOBAL TELECOMMUNICATIONS CONFERENCE, 2009. GLOBECOM 2009. IEEE, IEEE, PISCATAWAY, NJ, USA, 30 November 2009 (2009-11-30), pages 1-6, XP031645923, ISBN: 978-1-4244-4148-8 * the whole document * | 1-14 | |
| Y | CEDRIC MARCHAND ET AL: "Conflict resolution for pipelined layered LDPC decoders", SIGNAL PROCESSING SYSTEMS, 2009. SIPS 2009. IEEE WORKSHOP ON, IEEE, PISCATAWAY, NJ, USA, 7 October 2009 (2009-10-07), pages 220-225, XP031568758, ISBN: 978-1-4244-4335-2 * the whole document * | 1-14 | TECHNICAL FIELDS SEARCHED (IPC) |

-/--

The present search report has been drawn up for all claims

| Place of search | Date of completion of the search | Examiner |
|---|---|---|
| The Hague | 1 April 2011 | Belardinelli, Carlo |

EPO FORM 1503 03.82 (P04C01)

Europäisches
Patentamt

European
Patent Office

Office européen
des brevets

# EUROPEAN SEARCH REPORT

Application Number

EP 10 29 0645

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | ROVINI M ET AL: "Layered Decoding of Non-Layered LDPC Codes", DIGITAL SYSTEM DESIGN: ARCHITECTURES, METHODS AND TOOLS, 2006. DSD 200 6. 9TH EUROMICRO CONFERENCE ON, IEEE, PI, 1 January 2006 (2006-01-01), pages 537-544, XP031102327, ISBN: 978-0-7695-2609-6 * the whole document * | 1-14 | |
| A | YUAN-MAO CHANG ET AL: "Lower-Complexity Layered Belief-Propagation Decoding of LDPC Codes", IEEE INTERNATIONAL CONFERENCE ON COMMUNICATIONS, 2008 : ICC '08 ; 19 - 23 MAY 2008, BEIJING, CHINA, IEEE, PISCATAWAY, NJ, USA, 19 May 2008 (2008-05-19), pages 1155-1160, XP031265546, ISBN: 978-1-4244-2075-9 * the whole document * & WO 2009/143375 A2 (UNIV CALFORNIA [US]; WESEL RICHARD [US]; CHANG MAU-CHUNG FRANK [US]; C) 26 November 2009 (2009-11-26) | 1-14 | |
| A | WENGANG ZHOU ET AL: "VLSI Design for DVB-T2 LDPC Decoder", WIRELESS COMMUNICATIONS, NETWORKING AND MOBILE COMPUTING, 2009. WICOM '09. 5TH INTERNATIONAL CONFERENCE ON, IEEE, PISCATAWAY, NJ, USA, 24 September 2009 (2009-09-24), pages 1-4, XP031553101, ISBN: 978-1-4244-3692-7 * the whole document * | 1-14 | TECHNICAL FIELDS SEARCHED (IPC) |

The present search report has been drawn up for all claims

| Place of search | Date of completion of the search | Examiner |
|---|---|---|
| The Hague | 1 April 2011 | Belardinelli, Carlo |

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **M.P.C FOSSORIER ; M. MIHALJEVIC ; H. IMAI.** Reduced complexity iterative decoding of low-density parity check codes based on belief propagation. *IEEE Transactions on communications,* May 1999, vol. 47, 673-680
- **J. CHEN ; M. FOSSORIER.** Density evolution of two improved bp-based algorithms for LDPC decoding. *IEEE Communication letters,* March 2002
- **F. GUILLOUD ; E. BOUTILLON ; J.-L. DANGER.** lambda-min decoding algorithm of regular and irregular LDPC codes. *Proceedings of the 3rd International Symposium on Turbo Codes and Related Topics,* September 2003
- **C. JONES ; E. VALLES ; M. SMITH ; J. VILLASENOR.** Approximate-min* constraint node updating for LDPC code decoding. *IEEE Military Communication Conference,* October 2003, 157-162